Europäisches Patentamt

European Patent Office

Office européen des brevets

(11) Publication number: **0 261 828**

**A1**

## (12) EUROPEAN PATENT APPLICATION

(21) Application number: 87307888.5

(22) Date of filing: 07.09.87

(51) Int. Cl.⁴: **G01R 27/28**

(30) Priority: 15.09.86 GB 8622164

(43) Date of publication of application:
30.03.88 Bulletin 88/13

(84) Designated Contracting States:
AT BE CH DE ES FR GB IT LI NL SE

(71) Applicant: **Flann Microwave Instruments Ltd
Dunmere Road
Bodmin Cornwall PL31 2QL(GB)**

(72) Inventor: **Khoury, Khalil
Beechcroft House Scarletts Well Road
Bodmin Cornwall PL31 2PL(GB)**

(74) Representative: **Cross, Rupert Edward Blount
et al
BOULT, WADE & TENNANT 27 Furnival Street
London EC4A 1PQ(GB)**

(54) Microwave network analyser.

(57) The analyser includes a source (1) providing a microwave signal of known frequency; a detector (9) operative to provide a signal indicative of the magnitude of a microwave signal supplied thereto; a first directional coupler (3) by way of which the signal from the source (1) can be supplied to a network (5) under analysis and to the detector (9); a second directional coupler (4) by way of which a signal from the network (5) under analysis and deriving from the signal supplied thereto from the source (1) can be supplied to the detector (9); switch means (6, 7) selectively operable to supply either the signal from the first coupler (3) and/or the signal from the second coupler (4) to the detector (9), the switch means (6,7) providing at least two mutually different length paths for each of the signals supplied thereto; a third directional coupler (8) by way of which the output of the switch means (6,7) is coupled to the detector (9); and calculation means (11) responsive to signals from the detector (9) to calculate the vector ratio of the signals supplied to and from the network (5) under analysis.

FIG. 1.

# MICROWAVE NETWORK ANALYSER

This invention relates to a microwave network analyser.

In microwave network characterisation vector data is more informative than scalar data, and thus it is advantageous for any analyser used for network characterisation to operate on the basis of vector data. The vector data can be derived from a series of scalar measurements.

According to this invention there is provided a microwave network analyser, characterised by a source providing a microwave signal of known frequency; a detector operative to provide a signal indicative of the magnitude of a microwave signal supplied thereto; a first directional coupler by way of which the signal from the source can be supplied to a network under analysis and to the detector; a second directional coupler by way of which a signal from the network under analysis and deriving from the signal supplied thereto from the source can be supplied to the detector; switch means selectively operable to supply either the signal from the first coupler and/or the signal from the second coupler to the detector, the switch means providing at least two mutually different length paths for each of the signals supplied thereto; a third directional coupler by way of which the output of the switch means is coupled to the detector; and calculation means responsive to signals from the detector to calculate the vector ratio of the signals supplied to and from the network under analysis.

This invention will now be described by way of example with reference to the drawings, in which:-

Figure 1 is a schematic diagram of an analyser according to the invention for use in a reflective mode;

Figure 2 is a schematic diagram of another analyser according to the invention for use in a transmissive mode;

Figure 3 is a diagram illustrating signal relationships in a microwave network; and

Figures 4 and 5 are diagrams similar to Figure 3 but illustrating further relationships.

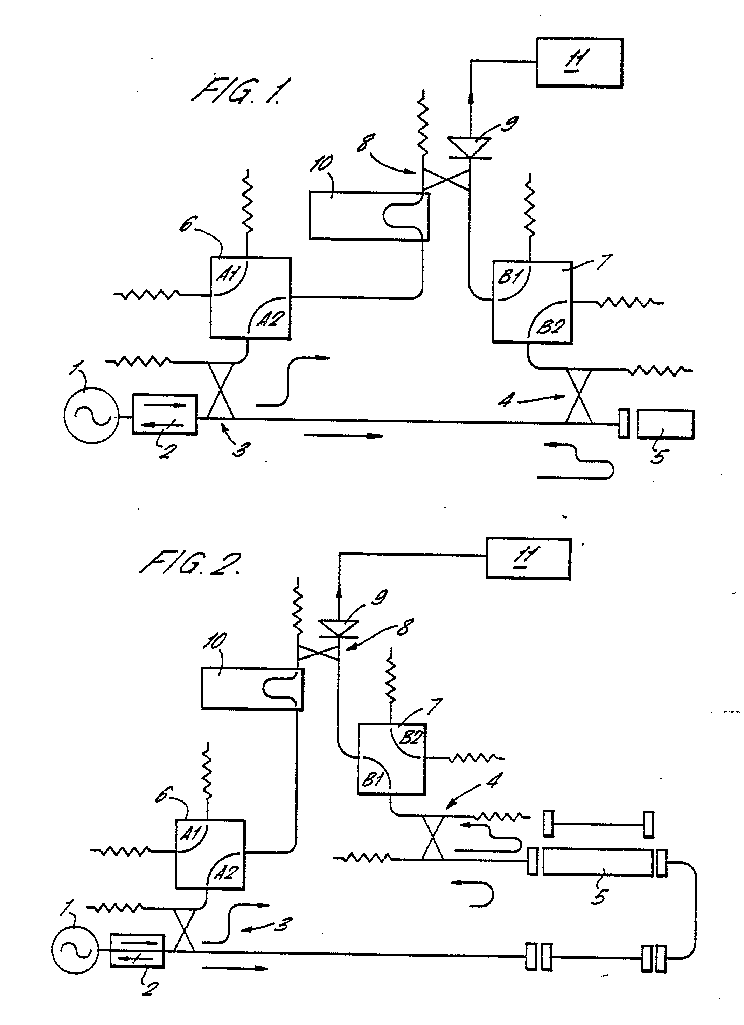

The analyser shown in Figure 1 comprises a source 1 for supplying a microwave signal of known frequency, which signal is supplied by way of an isolator 2, a first directional coupler 3 and a second directional coupler 4 as an input signal to a device 5 constituting a network under analysis. The signal from the source 1 is also supplied by way of the coupler 3 to a first switch device 6 which provides an isolation condition in which the signal is diverted into a matched termination, and two selectable pass conditions providing mutually-different-length paths for the signal. The input signal supplied to the device 5 under analysis passes after reflection therefrom through the coupler 4 to a second switch device 7 similar to the first switch device 6. The signals from the switch devices 6 and 7 are supplied by way of a third directional coupler 8 to a detector 9, the signal from the first switch device 6 passing to the coupler 8 by way of a line length correction device 10, the function of which will be described later. The signal supplied to the detector 9 will be either a sample from the source 1, a sample from the device 5, or a combination of the two with different phases. The detector 9 which can be constituted by a bolometer, a thermistor, a thermo-electric converter, a homodyne receiver crystal detector or a mixer with an IF receiver, serves to measure the magnitude of the signal received, and supplies this measurement to a computer 11 which controls operation of the analyser. With any such detector apart from the mixer, a low pass filter should precede the detector to remove harmonic frequencies of the source.

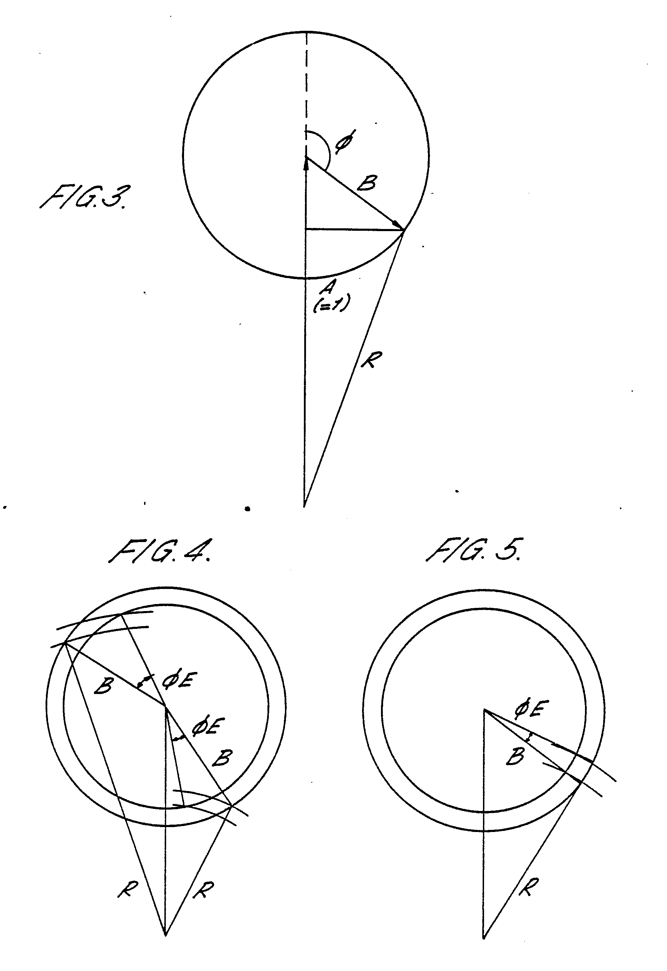

The analyser shown in Figure 2 is basically similar to that shown in Figure 1, and corresponding parts have the same references. The essential difference is that in the analyser of Figure 2 the signal from the source 1 is supplied to the device 5 directly from the first coupler 3, and does not pass through the second coupler 4. Further, the signal is transmitted through the device 5 rather than being reflected therefrom, before being passed by the coupler 4 to the second switch device 7.

Operation of the above described analysers will now be described with reference to Figures 3, 4 and 5 of the drawings.

Figure 3 illustrates the relationship between the input signal (A) supplied to the device 5 under analysis, and the reflected or transmitted signal (B) obtained from the device 5 and derived from the input signal (A). In the diagram the input signal A is represented by vector A and signal B is represented by vector B, the resultant signal (R) obtained by combining signals A and B being shown as vector R.

By measuring the ratio of the magnitude of signal B to that of signal A, and the ratio of the magnitude of signal R to that of signal A (equating the magnitude of signal A to unity to normalise the data), it is possible to calculate the phase angle $\phi$ between vectors A and B, as follows:-

$$R^2 = (B \sin \phi)^2 + (1 + B \cos \phi)^2$$
$$= B^2 \sin^2 \phi + 1 + 2 B \cos \phi + B^2 \cos^2 \phi$$
$$= B^2 (\sin^2 \phi + \cos^2 \phi) + 1 + 2B \cos \phi$$
$$= B^2 + 1 + 2B \cos \phi$$

$$\cos \phi = \frac{R^2 - B^2 - 1}{2B}$$

To this end, the computer 11 controls the switch devices 6 and 7 such that signals A and B are supplied first independently and then together to the detector 9 for the magnitude of the signals A, B and R to be determined, these measurements being supplied to the computer 11 for processing as above to determine the phase angle $\phi$.

The above processing does not yield the sign of the phase angle, and this is achieved by varying the phase by which the two signals A and B are combined, by selecting a new path length for one or both of the signals by appropriate operation of the switch devices 6 and 7, and then remeasuring, the sign of the phase angle then being deduced from the measurements obtained. As before, control of the analyser to effect such measurement and the necessary calculations are carried out by the computer 11.

Best phase angle measurement accuracy is obtained when the vectors B and R are 90° apart; see Figures 4 and 5 where $\phi$ E is due to any errors in measuring the magnitudes of signals B and R, Figure 4 showing large $\phi$ E and non-90° relationships between vectors B and R and Figure 5 showing small $\phi$ E and a 90° relationship between vectors B and R. The necessary relationship between vectors B and R can be obtained by selection of the phase by which the signals A and B are combined, this selection being accomplished by appropriate operation of the switch devices 6 and 7.

In the analysers described above in which each switch device 6 or 7 provides two mutually different length paths for the associated signal A or B, four discrete phase combinations of the signals A and B can be obtained. It will be appreciated that switch devices having more than two paths can otherwise be used if more discrete combinations are necessary.

In practice the phase of any given path length varies with the frequency of the signal, and the necessary incremental path lengths L for the switch devices 6 and 7 can be calculated from the expression:-

L = (Lghf x Lglf)/(2x(Lghf x (n-1) + Lglf))

where Lghf is the wavelength in the switch medium of the highest frequency of interest;
Lglf is the wavelength in the switch medium of the lowest frequency of interest; and
n is the number of combinational settings of the switch devices.

Inadmissable L values are when it is equal to or nearly equal to 0 or to a multiple of half waveguide wavelength at a frequency within the frequency band of interest. This will occur in analysers with wide frequency band coverage and can be overcome by increasing the number of path lengths through the switch devices 6 and 7, as described above.

To allow for frequency interpolation of the calibration measurements carried out, the phase dispersion within the analyser should be kept to a minimum, that is the total path length for signal A should be equal to that of signal B, and this is achieved by means of the line length correction device 10. For best results interaction between the detector 9 and the remainder of the analyser should be kept to a minimum, and this can be achieved by maintaining a good VSWR when viewed back from the detector 9, by appropriate selection of the coupling factors of the couplers 3, 4 and 8.

An advantage of the analysers described above is that only one detector is used to measure the magnitudes of the signals A, B and R, this obviating the need to match different detectors at different levels over a range of frequencies. However, if greater speed of operation is required a plurality of matched detectors and couplers can be used together with parallel data processing in the controlling computer.

For complete analysis of a network under test measurements of the magnitudes of the A, B and R signals for each of a plurality of different frequency input signals (A) can be carried out, or otherwise measurements for each of a plurality of different frequency A signals can be carried out, followed by measurement of all the associated B signals and then of the associated R signals.

A particular advantage of analysers as described above is that all necessary control and calculation can be carried out automatically by the computer with no operator intervention being necessary, the computer providing the results of the calculations in a required form.

With reflection mode operation (Figure 1) the results obtained can be influenced by imperfections in components of the analyser, eg. the finite directivity of the couplers used. This can be overcome by first measuring a known microwave standard with the analyser, and using the results obtained to determine any errors introduced by the analyser. This information can then be stored and used as calibration data to correct measurements obtained during subsequent use of the analyser with devices under test.

A further advantage of the analysers described above is that they have a slow variation of calibration with changing frequency of the input signal, and this allows interpolation of the calibration data to the measurement frequencies without the need to recalibrate for each frequency.

It will be appreciated that with the aid of appropriate switches analysers as described above can be used together to measure both the transmission and reflection properties, in both directions, of a two-port device under test.

## Claims

1. A microwave network analyser, characterised by a source (1) providing a microwave signal of known frequency; a detector (9) operative to provide a signal indicative of the magnitude of a microwave signal supplied thereto; a first directional coupler (3) by way of which the signal from the source (1) can be supplied to a network (5) under analysis and to the detector (9); a second directional coupler (4) by way of which a signal from the network (5) under analysis and deriving from the signal supplied thereto from the source (1) can be supplied to the detector (9); switch means (6, 7) selectively operable to supply either the signal from the first coupler (3) and/or the signal from the second coupler (4) to the detector (9), the switch means (6, 7) providing at least two mutually different length paths for each of the signals supplied thereto; a third directional coupler (8) by way of which the output of the switch means (6, 7) is coupled to the detector (9); and calculation means (11) responsive to signals from the detector (9) to calculate the vector ratio of the signals supplied to and from the network (5) under analysis.

2. An analyser as claimed in Claim 1, characterised in that the signal from the source (1) is supplied to the network (5) under analysis by way of the second coupler (4).

3. An analyser as claimed in Claim 1 or Claim 2, characterised in that the switch means comprises first and second switches (6 and 7) each providing an isolation condition and at least two mutually-different-length paths in the pass condition.

4. An analyser as claimed in any preceding claim, characterised by a delay means (10) in the path for the signal from the source (1) between the switch means (6, 7) and the third coupler (8).

5. An analyser as claimed in any preceding claim, characterised in that the calculation means is a computer (11) which also controls operation of the analyser.

6. An analyser as claimed in any preceding claim, characterised by a store storing calibration data obtained by measurement of a known microwave standard with the analyser, the calibration data being used to correct measurements obtained during subsequent use of the analyser.

FIG. 1.

FIG. 2.

FIG.3.

FIG.4.

FIG.5.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.3) |
|---|---|---|---|
| X | FIRMENDRUCKSCHRIFT, Product note No. 8510-1, 15th May 1985, EPA, pages 1-15; HEWLETT PACKARD "Millimeter-wave vector measurements using the HP 8510A network analyzer" * pages 1-7; right-hand column * | 1,5,6 | G 01 R 27/28 |
| A | idem | 2,3 | |
| A | FIRMENDRUCKSCHRIFT, Product note 11729C-2, 23rd January 1986, EPA, pages 1-41; HEWLETT PACKARD "Phase noise characterization of microwave oscillators frequency discriminator method" * page 12; figure 3.4. * | 4 | |

**TECHNICAL FIELDS SEARCHED (Int. Cl.3)**

G 01 R 27/28

The present search report has been drawn up for all claims

| Place of search | Date of completion of the search | Examiner |
|---|---|---|
| BERLIN | 08-12-1987 | LEMMERICH J |

EPO FORM 1503 03.82 (P0401)